# EUROPEAN PATENT SPECIFICATION

(11) **EP 0 796 939 B1**
(45) Date of publication and mention of the grant of the patent: **17.10.2001**
(21) Application number: 97301793.2
(22) Date of filing: 18.03.1997
(51) Int. Cl.: D04B 15/78

(54) **Piezoelectric needle selection device for knitting machines**
Piezoelektrische Nadelauswahlvorrichtung für Strickmaschinen
Dispositif de sélection d'aiguilles piezo-électrique pour des machines à tricoter

(30) Priority: 19.03.1996 JP 9043596
(43) Date of publication of application: 24.09.1997
(73) Proprietor: PRECISION FUKUHARA WORKS, LTD, Kobe, Hyogo 658 (JP)
(72) Inventor: Shibata, Takao, Takatsuki, Osaka 569 (JP)
(74) Representative: Warren, Keith Stanley

(56) References cited:
- EP-A- 0 210 790
- EP-A- 0 335 099
- DE-A- 3 933 149
- FR-A- 2 512 471
- GB-A- 2 121 836
- US-A- 4 604 877

## Description

### Field of the Invention

The present invention relates to knitting machines and, more particularly, to a needle selection device for knitting machines.

### Background of the Invention

It is a common practice to provide knitting machines with jacquard pattern devices for knitting various patterns in knit fabrics. There are several different kinds of such jacquard pattern devices with several different kinds of needle selection mechanisms, such as pattern wheels, selection sliders, pattern drums and electronic pattern devices. The present invention relates to an a knitting machine having improved electronic pattern device and, more specifically, to an improved piezoelectric pattern device.

It is known to use a piezoelectric device to control needle selection members of a knitting pattern mechanism. A typical such piezoelectric pattern mechanism is disclosed in DE-A-3 933 149. This pattern mechanism includes a piezoelectric body having a piezoelectric element, which moves upwardly and downwardly upon application of a voltage thereto. The front end of the piezoelectric body is linked to a movably mounted finger and the piezoelectric body and the finger are arranged in a straight line. The rear end of the piezoelectric body is supported within a groove in a supporting housing and the medial portion of the piezoelectric body is held by a rotating member rotatably mounted on the supporting housing.

In jacquard knitting, the needles move between three operating positions, i.e. knit, tuck and welt positions. Heretofore, to achieve such movement to these three operating positions, the piezoelectric pattern mechanisms required that the fingers be divided into left and right rows, with one row of fingers for selecting those needles to be moved to the welt position and the other row of fingers for selecting those needles to be moved to the tuck position. If one row has eight fingers, for example, the other row also must have eight fingers, resulting in two rows with a total of sixteen fingers arranged in a zigzag pattern.

The large number of fingers required creates significant problems because the number of piezoelectric bodies, and the number of other components and wiring, increase proportionately to the number of fingers. In addition, if the two rows of fingers are arranged on the same horizontal level, as they most often are, the piezoelectric bodies of both rows must have the same capacity, inevitably requiring a large pattern mechanism.

### Summary of the Invention

With the foregoing in mind, it is an object of the present invention to provide a knitting machine having a piezoelectric pattern mechanism which overcomes and obviates the problems, disadvantages and deficiencies heretofore encountered with prior piezoelectric pattern mechanisms.

To this end, the present invention consists in a knitting machine including knitting needles movable between knit, tuck and welt positions to form stitch loops in a predetermined pattern, and pattern controlled needle selection means for selecting particular needles to be moved to and between the knit, tuck and welt positions in accordance with said pattern, characterized in that said needle selection means includes a piezoelectric body movable between three operative positions corresponding to the knit, tuck and welt positions of said needles, first driving means for causing said piezoelectric body to move to one of its operative positions, second driving means for causing said piezoelectric body to move to another one of its operative positions, and third driving means for causing said piezoelectric body to move to the remaining one of its operative positions, whereby said piezoelectric body selects and causes a needle to move between its three operative positions in accordance with said predetermined pattern.

With the invention, therefore, the piezoelectric pattern mechanism may require only a single row of fingers, each of which is capable of selecting any one of the three operating positions of the knitting needles.

In a preferred embodiment, the needle selection means includes a first driving means which causes the piezoelectric body to displace upwardly, a second driving means which causes the piezoelectric body to displace downwardly, and a third driving means for causing the piezoelectric body to displace to the neutral position. Preferably, the needle selection means is combined with a needle mechanism of a knitting machine in which individual needles are selected by selector jacks which in turn operate spring jacks. Such selector jacks and spring jacks are disclosed in US-A-Patent No 4 604 877.

### Brief Description of the Drawings

An embodiment of the present invention will now be described by way of example with reference to the accompanying drawings, in which:
Figure 1 is a partial perspective view of a piezoelectric body connected to a first type of finger for use with the present invention;
Figure 2 is a schematic view of control means and driving means for the piezoelectric body of Figure 1;
Figure 3 is a schematic view similar to Figure 2 of another embodiment of the control means and driving means for the piezoelectric body of Figure 1;
Figure 4 is a table of typical output signal states of the driving means of Figure 3;
Figures 5a, 5b and 5c are schematic views of the three displaced positions of the piezoelectric body of Figure 1;
Figure 6 is a schematic view of an output signal diagram of the piezoelectric body of Figure 1;
Figure 7 is a fragmentary, vertical sectional view of a knitting machine incorporating the present invention;
Figure 8 is an enlarged, fragmentary, schematic view of a cam arrangement of the knitting machine of Figure 7;
Figure 9 is an enlarged, fragmentary elevational view of a knitting needle, spring jack and selector jack of the knitting machine of Figure 7;
Figure 10 is an enlarged, fragmentary perspective view of the selector jack, spring jack, cancelling cam, selector jack raising cam and selector jack welt and tuck cams of the knitting machine of Figure 7;
Figure 11 is an enlarged, fragmentary perspective view of a second type of finger operated by the piezoelectric body;
Figure 12 is a schematic view of a needle-motion diagram illustrating the three operational positions of the needle;
Figure 13 is a schematic view illustrating the relationship between the finger and the welt and tuck cams to cause the needle to move to the welt and tuck positions;
Figure 14 is a schematic view illustrating the relationship between the master butt of the selector jack and the welt and tuck cams to move the selector jacks to the tuck and welt positions;
Figures 15a, 15b and 15c are schematic views illustrating the operation of the first type of finger; and
Figures 16a, 16b and 16c are schematic views similar to Figures 15a, 15b and 15c illustrating the operation of the second type of finger.

### Detailed Description of the Preferred Embodiments

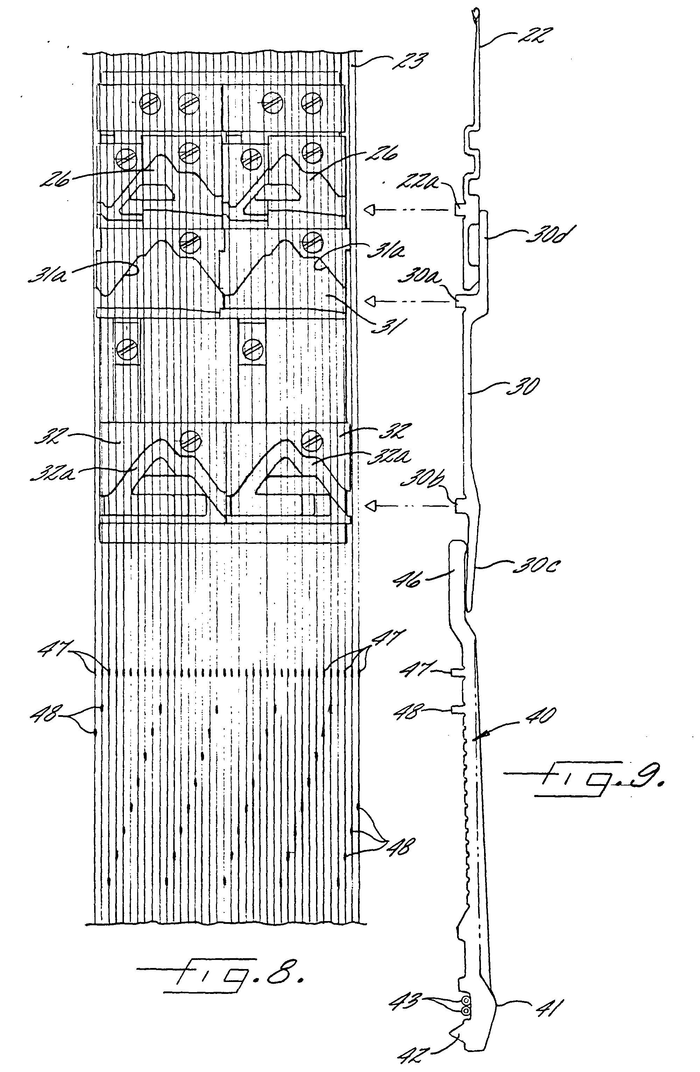

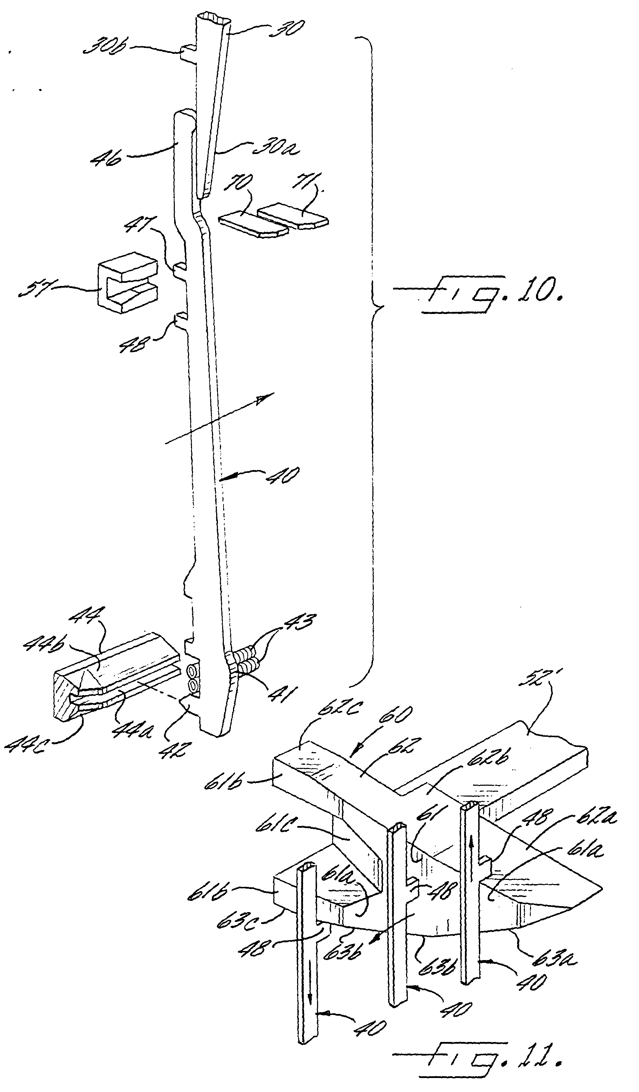

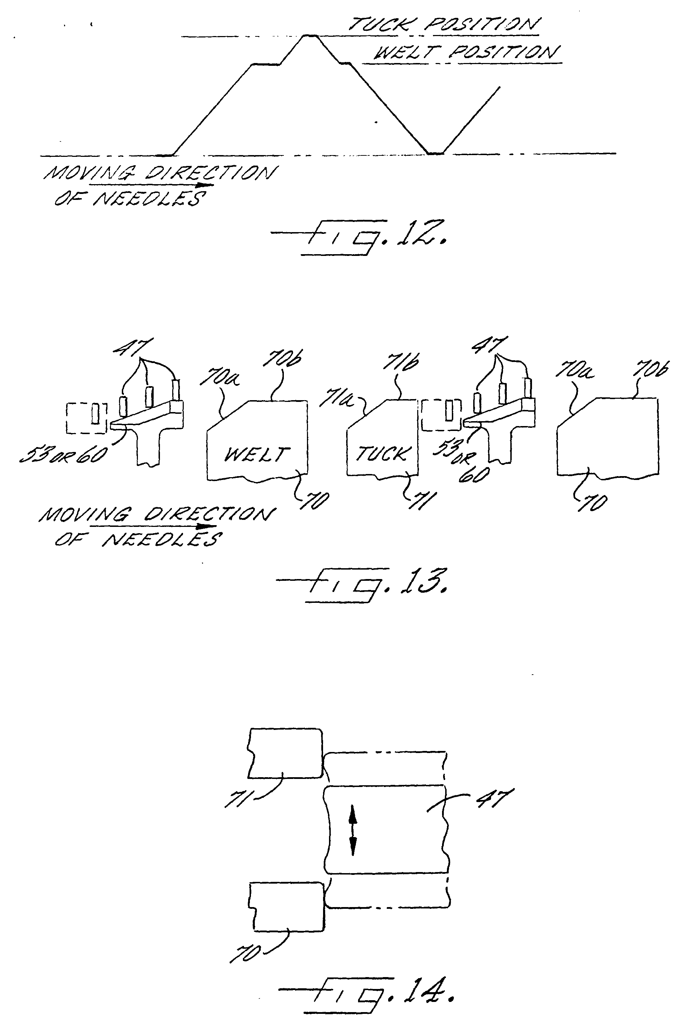

Referring now more particularly to the drawings and specifically to Figure 7, there is illustrated therein a circular knitting machine, generally indicated at **20,** incorporating the present invention. Knitting machine **20** includes a needle cylinder **21** having a multiplicity of grooves **21a** in the outer periphery thereof. In each groove **21a,** a knitting needle **22** is slidably mounted for vertical movement between three operation positions, i.e. knit, tuck and welt positions.

Knitting machine **20** further includes a cam supporting block **23** which is carried by an upper cam ring **24.** Upper cam ring **24** is in turn supported on a lower cam ring **25.**

A stitch cam **26** is supported on the inner face of cam block **23** and includes a cam race **26a.** Cam race **26a** receives an operating butt **22a** of needle **22** to move needle **22** upwardly and downwardly in accordance with a predetermined pattern.

A spring jack **30** is disposed in each groove 21a of the needle cylinder **21** below each needle **22.** Spring jack **30** is substantially identical to the spring jack described in our JP-A-8199453 or US-A-5 647 230. Accordingly, spring jack **30** will not be described in detail herein except as is necessary for an understanding of the operation thereof.

Spring jack **30** includes a raising butt **30a,** a lowering butt **30b** and a lower portion or tail **30c.** Spring jack **30** also includes an offset upper portion **30d,** which overlaps the lower end of needle **22** and defines with butt **30a** a shoulder for contacting the lower end of needle **22**. Cam block **23** carries a raising cam **31** having a cam race **31a** cooperating with butt **30a** and a lowering cam **32** having a cam race **32a** cooperating with lowering butt **30b.**

A selector jack, generally indicated at **40,** is mounted in each groove **21a** of cylinder **21** beneath spring jack **30.** The upper end portion **40a** of the selector jack overlaps the lower portion or tail **30c** of spring jack **30.** Selector jack **40** is also described substantially in our aforementioned Japanese and US Patent Specifications.

Selector jack **40** has a first pivot portion **41** which contacts the bottom of the groove **21a** and a V-shaped projection **42** at the lower end thereof. A pair of coil girdle springs **43** biases the lower portion of selector jack **40** toward the bottom of the groove **21a,** while permitting limited upward and downward movement of the selector jack **40** in the groove **21a.** A stop plate **45** is mounted on upper cam ring **24** and limits the outward movement of the selector jack **40** to maintain the upper end portion **46** of selector jack **40** in position and in contact with the tail **30c** of spring jack **30.**

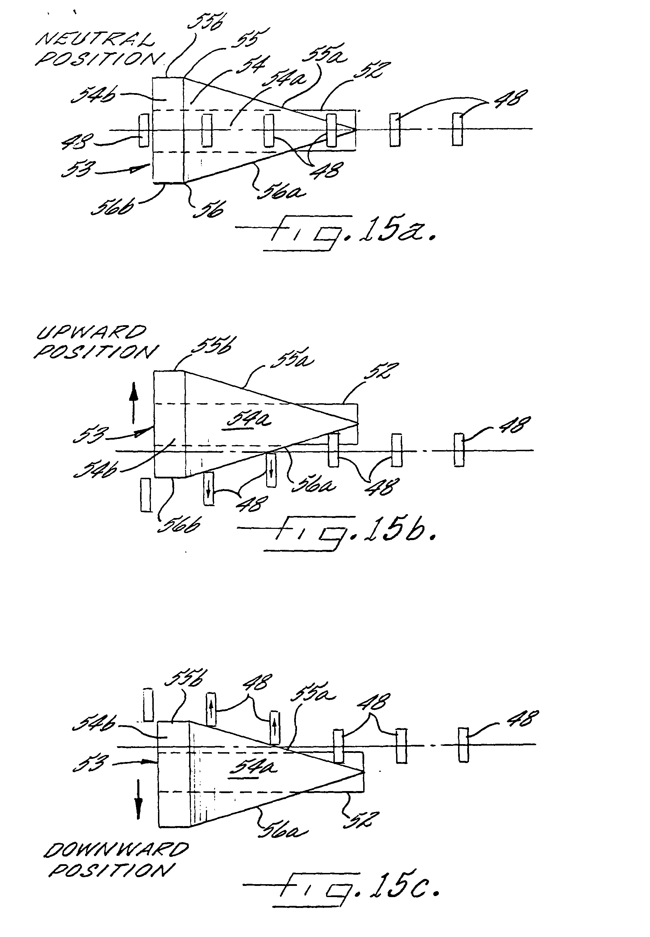

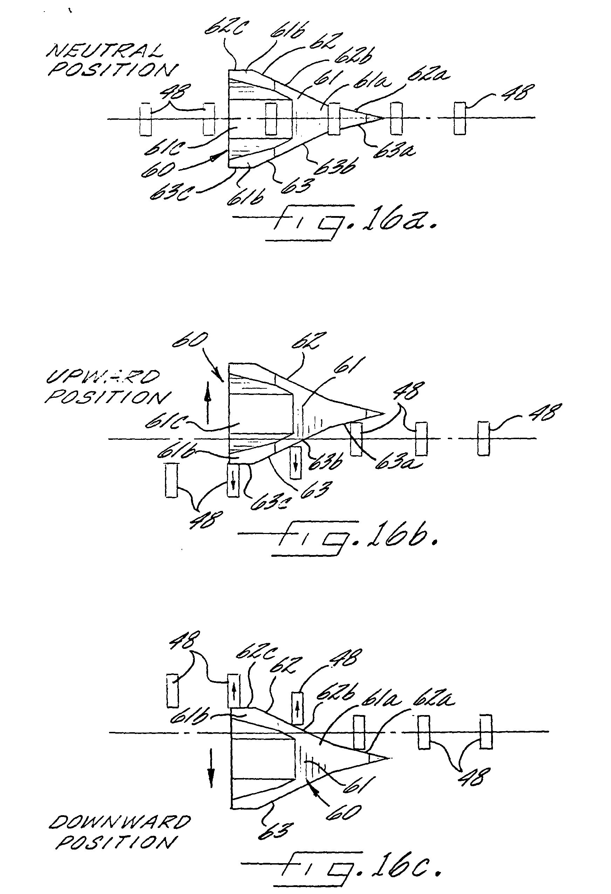

Selector jack **40** includes a master butt **47** and a pattern butt **48** below the master butt **47** (Figure 9). Master butts **47** are respectively at the same level from selector jack to selector jack, while pattern butts **48** on adjacent selector jacks form a row of butts arranged diagonally and with a clearance with each other (Figure 8).

If desired, the selector jacks **40** may be formed of a relatively thin or narrow elastic or flexible member so as to alleviate the shock that is generated during operation of the knitting machine **20.**

The lower cam ring **25** supports a selector jack supporting member **44** for receipt of the V-shaped projection **42** of selector jack **40.** Selector jack supporting member **44** preferably has a V-shaped groove **44a** therein (Figure 10) to receive the V-shaped projection **42.** V-shaped groove **44a** and V-shaped projection **42** thusly maintain the selector jack **40** at a certain level in normal operation. If desired, supporting member **44** may be provided with an upper sloping surface **44b** and a lower sloping surface **44c** to stabilize better the position of the selector jack **40** which has been moved up or down in a manner to be presently described.

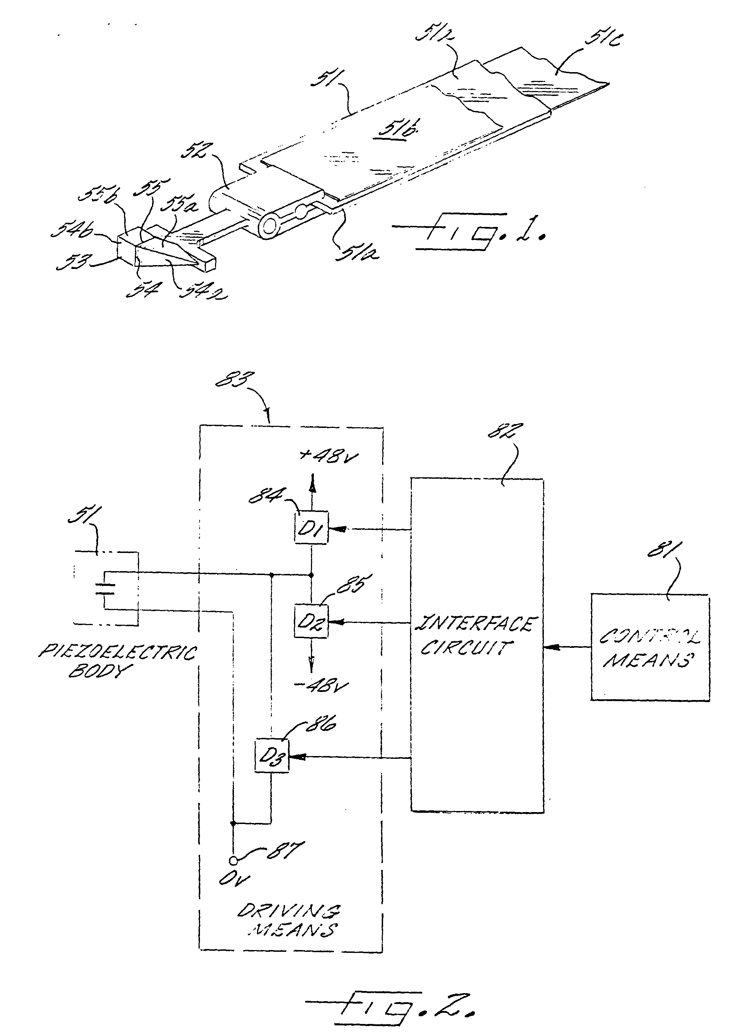

A piezoelectric needle selecting device, generally indicated at **50** (Figure 7) is carried by lower cam ring **25** adjacent the path of travel of the selector jacks **40** as they travel with cylinder **21** as it rotates. Piezoelectric needle selecting device **50** includes a plurality of piezoelectric bodies **51** (Figure 1). The piezoelectric bodies **51** are identical and, therefore, only one will be described. The piezoelectric body **51** (Figure 1) includes a plate member **51a** having piezoelectric elements **51b** and **51c** attached to opposite sides thereof. These piezoelectric elements may be, for example, a bimorph-type ceramic actuator.

A finger **52** is coupled to the outer end of the plate member **51a** of piezoelectric body **51** in a movable manner. Finger **52** carries an actuating head, generally indicated at **53,** at its outer end for selective engagement with pattern butt **48** of selector jack **40.** Each actuating head **53** includes a front end face **54** having an inwardly sloping surface **54a** and a vertical surface **54b** downstream of inwardly sloping surface **54a.** Actuating head **53** also includes an upper face **55** having an upwardly sloping surface **55a** and an upper horizontal surface **55b.** Actuating head **53** has a comparable lower face **56** with a downwardly sloping surface **56a** and a horizontal surface **56b** downstream thereof.

Depending on which of the three operational positions which the piezoelectric body **51** occupies, the pattern butt **48** of a selector jack **40** will contact one of these three faces **54, 55** or **56** and the selector jack 40 will thus be moved inwardly if face **54** is contacted, upwardly if face **55** is contacted or downwardly if face 56 is contacted. A cancelling cam **57** is provided in the path of the master butts **47** to ensure that each selector jack **40** is properly positioned for the piezoelectric needle selecting device **50** and the actuating head **53** (Figures 15a, 15b and 15c).

Referring to Figures 11, 16a, 16b and 16c, there is illustrated another embodiment of an actuating head **60** carried by the outer end of the finger **52'.** Actuating head **60** has a front face **61** having an inwardly sloping surface **61a,** a bifurcated vertical surface **61b** and an outwardly sloping surface **61c** between the bifurcations of vertical surface **61b.** Actuating head **60** also includes an upper face **62** having a first upwardly sloping surface **62a,** a second upwardly sloping surface **62b** downstream of the first upwardly sloping surface **62a** and a horizontal surface **62c.** Actuating head **60** has a corresponding lower face **63** having a first downwardly sloping surface **63a,** a second downwardly sloping surface **63b** and a horizontal surface **63c.**

When finger **52'** is in the neutral operating position, actuating head **60** contacts pattern butt **48** of selector jack **40** and pattern butt **48** moves along inwardly sloping surface **61a** which pushes the selector jack **40** inwardly. Butt **48** next contacts outwardly sloping surface **61c** which gradually returns the selector jack **40** and spring jack **30** to their original positions while alleviating any shock which may be caused when butt **30b** of spring jack **30** contacts raising cam **31**.

When finger **52'** is either raised or lowered, butt **48** moves along the surface **62** or **63** and selector jack **40** is raised or lowered. The first sloping surface **62a** or **63a** moves the selector jack **40** upwardly or downwardly to the first step and the second sloping surface **62b** or **63b** moves the selector jack **40** upwardly or downwardly to the second step. The horizontal length of the second sloping surface **62b** or **63b** may be relatively short, which is effective for fine gauge knit fabrics which have a limited needle-selecting range. Preferably, the upward or downward movement of the selector jacks **40** is assisted by the sloping surface **44b** or **44a,** respectively, of selector jack supporting member **44.**

A welt cam **70** and a tuck cam **71** are carried either by the lower cam ring **25** or the upper cam ring **24** by suitable supports (not shown). Cam **70** includes an inwardly sloping surface **70a** and a horizontal surface **70b** (Figures 10 and 13). Cam **71** also has an inwardly sloping surface **71a** and a horizontal surface **71b.** As shown in Figure 14, cams **70** and **71** are mounted at different heights relative to the master butt **47** of the selector jack **40** such that neither of these cams are contacted by the master butt **47** when the piezoelectric body **51** is in the neutral position and cam **70** is contacted by the master butt **47** when the piezoelectric body **51** is displaced downwardly and cam **71** is contacted thereby when the piezoelectric body **50** is displaced upwardly.

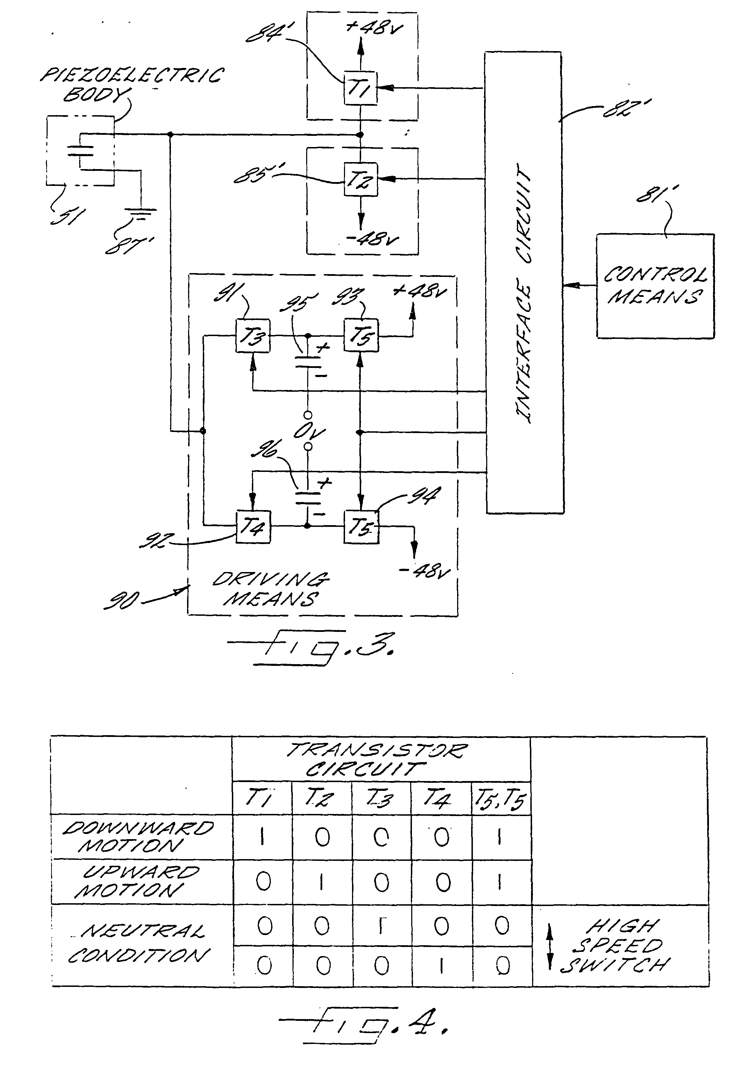

Referring now to Figure 2, there is illustrated schematically a pattern control system, generally indicated at **80,** for the piezoelectric body **51.** Control system **80** includes a control means **81,** an interface circuit **82** and driving means, generally indicated at **83.** Driving means **83** includes a first driving or switching means **84** (labeled D₁), which may be a first transistor circuit, a second driving or switching means **85** (labeled D₂), which may be a second transistor circuit, and a third driving or switching means **86** (labeled D₃), which may be a third transistor circuit. The first, second and third switching means **84, 85** and **86** are all connected in parallel to the piezoelectric body **51.** In addition, first switching means **84** is connected to a positive voltage of a first potential, for example, +48 volts and second switching means **85** is connected to a negative voltage of a second potential, for example, -48 volts. All three switching means are connected to ground as is indicated at **87.**

The control means **81** outputs, for example, three kinds of two-bit information signals, such as "0,0"; "1,0" and "0,1". These output signals are delivered to interface circuit **82** which converts the two-bit information signals to actuating signals for the first, second and third switching means **84, 85** and **86.** For example, when information signal "0,0" is output from control means **81** to interface circuit **82**, interface circuit **82** outputs an actuating signal to open the first and second switching means **84** and **85** while third switching means **86** is closed and short circuits the piezoelectric body **51.** Piezoelectric body **51** is caused to move to the neutral position. When information signal "1,0" is output, interface circuit **82** outputs an actuating signal to open the second and third switching means **85** and **86** while closing the first switching means **84.** First switching means **84** then applies a positive voltage of, for example, +48 volts to the piezoelectric element **51b** which causes the piezoelectric body **51** to be displaced upwardly. Similarly, when information signal "0,1" is output by control means **81,** interface circuit **82** outputs an actuating signal to open the first and third switching means **84** and **86** while closing the second switching means **85**. Second switching means **85** applies a negative voltage of, for example, -48 volts to piezoelectric element **51a** to cause piezoelectric body **51** to be displaced downwardly.

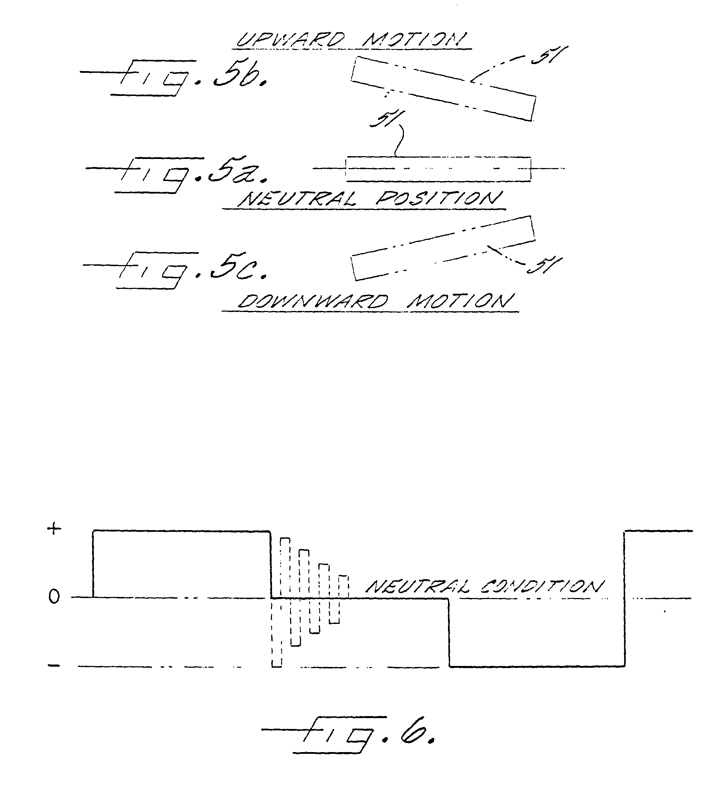

Referring now to Figure 3, there is illustrated another embodiment of a control for the piezoelectric body **51**, wherein like reference characters are used to refer to like elements with the prime notation added. A control means **81'** is provided and outputs three two-bit information signals to an interface circuit **82'.** Interface circuit **82'** converts the two-bit information signals to actuating signals and outputs such actuating signals to a first switching means **84'** (labeled T₁), a second switching means **85'** (labeled T₂), and a driving means, generally indicated at **90.** Driving means **90** includes first, second, and paired third and fourth switching means **91** (labeled T₃), **92** (labeled T₄) and **93** (labeled T₅), **94** (also labeled T₅). As before, all of these switching means **84', 85', 91, 92** and **93, 94** may be transistor circuits, and all are connected to the piezoelectric body **51** and to ground as indicated at **87'.**

Switching means **91** and **93** are connected in series, as are switching means **92, 94.** A capacitance means, which may be a pair of capacitors **95, 96** are connected across the series connected switching means **91, 93** and **92, 94.**

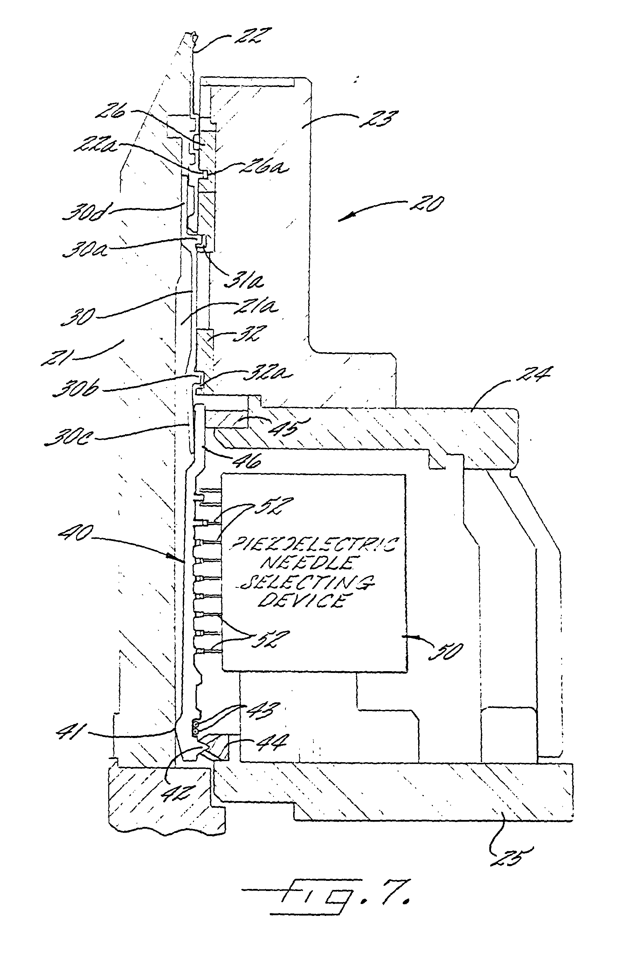

When control means **81'** outputs an information signal "0,0", interface circuit **82'** outputs an actuating signal to switch off switching means **84', 85', 93** and **94** and switches the switching means **91** and **92** on and off quickly and alternately. The capacitors **95, 96,** which have been precharged, are discharged. As shown in Figure 6, positive (+) and negative (-) voltages are alternately applied, resulting in a more neutral condition (Figure 5a) .

When information signal "1,0" is output by control means **81',** interface circuit **82'** outputs an actuating signal to switch on the switching means **84'** and switch off the switching means **85', 91** and **92.** Switching means **93** and **94** are switched on to charge the capacitors **95** and **96.** Switching means **84'** applies a positive voltage of, for example, +48 volts to piezoelectric body **51** causing the front end thereof to displace downwardly (Figure 5c).

When control means **81'** outputs the information signal "0,1", interface circuit **82'** outputs an actuating signal to switch on the switching means **85'** and switch off the switching means **84', 91** and **92** and to switch on the switching means **93, 94** to charge the capacitors **95, 96.** Switching means **85'** applies a negative voltage of, for example, -48 volts to piezoelectric body **51** to cause the front end thereof to displace upwardly (Figure 5b). Figure 4 is a table which correlates the three operational positions of the piezoelectric body **51** and the operating conditions of the transistor circuits or switching means **84', 85', 91, 92, 93** and **94** (labeled T₁, T₂, T₃, T₄ and T₅, T₅).

The operation of the apparatus of the present invention will now be described. A pre-programmed pattern device (not shown) causes the control means **81** or **81'** to output the requisite two-bit information signals to cause the piezoelectric body **51** to occupy a particular position of its three operating positions to achieve a corresponding movement of the knitting needle **22** to the knit, tuck or welt position as is necessary to duplicate the pattern to be knit. If the pattern calls for the needle **22** to be moved to the knit position, the piezoelectric body **51** is caused to move to the neutral position (Figure 5a) in a manner previously described.

The selector jack **40** is not raised or lowered but the pattern butt **48** thereof engages and moves along the front face **54** or **61** of the finger **53** or **60** which pivots the selector jack **40** inwardly. 2ne master butt **47** of the selector jack **40** passes between the cams **70** and **71** and the spring jack **30** is raised by cams **32** to raise needle **22.** Needle **22** is then raised by stitch cam **26** to the knit position.

If the pattern calls for the needle **22** to be raised to the tuck position, the piezoelectric body **51** is caused to move downwardly (Figure 5c) so that pattern butt **48** on the selector jack **40** engages and moves along upper face **55** or **62** of actuating head **53** or **60** to raise selector jack **40** upwardly and to cause master butt **47** to engage the tuck cam **71.** Tuck cam **71** moves selector jack **40** inwardly and causes spring jack **30** to be moved by cam **32** to the tuck position and correspondingly to cause needle **22** to be moved to the tuck position by stitch cam **26.**

Needle **22** is moved to the welt position by piezoelectric body **51** moving upwardly which causes pattern butt **48** to engage and move along the lower face **56** or **63** of head **53** or **60** to move the selector jack **40** downwardly Welt cam **70** will then force selector jack **40** inwardly which will cause spring jack **30** to engage the welt cam track of cam **32** and thus needle **22** to engage the welt cam track of stitch cam **26.**

In this manner, needle selection in accordance with a preprogrammed or predetermined pattern is accomplished using piezoelectric elements with only half of the usual number of fingers and actuating heads.

## Claims

1. A knitting machine **(20)** including knitting needles **(22)** movable between knit, tuck and welt positions to form stitch loops in a predetermined pattern, and pattern controlled needle selection means **(50)** for selecting particular needles **(22)** to be moved to and between the knit, tuck and welt positions in accordance with said pattern, **characterized in that** said needle selection means **(50)** includes
a piezoelectric body **(51)** movable between three operative positions corresponding to the knit, tuck and welt positions of said needles **(22),**
first driving means **(84)** for causing said piezoelectric body **(51)** to move to one of its operative positions,
second driving means **(85)** for causing said piezoelectric body **(51)** to move to another one of its operative positions, and
third driving means **(86)** for causing said piezoelectric body **(51)** to move to the remaining one of its operative positions, whereby said piezoelectric body **(51)** selects and causes a needle **(22)** to move between its three operative positions in accordance with said predetermined pattern.

2. A knitting machine **(20)** according to Claim 1 wherein said needle selection means **(50)** includes control means **(81)** for outputting three control signals to control said first, second and third driving means **(84, 85, 86).**

3. A knitting machine **(20)** according to Claim 1 or 2 wherein said piezoelectric body **(51)** comprises an elongate base member **(51a)** and at least one piezoelectric element **(51b)** carried by said base member **(51a)** and movable to a first position upon application of a voltage of a first potential, movable to a second position upon application of a voltage of a second potential different from said first potential and movable to a third position upon application of a voltage of a third potential intermediate the first and second potentials.

4. A knitting machine **(20)** according to Claim 3 wherein said first and second potentials are voltages of equal value but opposite polarity.

5. A knitting machine **(20)** according to Claim 3 or 4 wherein said third potential is zero.

6. A knitting machine **(20)** according to Claim 3 or 4 wherein said third potential comprises outputs of opposite polarity of two capacitors applied quickly and alternately until said capacitors are discharged to zero.

7. A knitting machine according to Claim 1 including spring jacks **(30)** operatively associated with said knitting needles **(22)** for moving said knitting needles **(22)** between the knit, tuck and welt positions,and selector jacks **(40)** for selectively activating said spring jacks **(30)** to move said needles **(22)** said needle selection means **(50)** including actuating means **(53,60)** for moving said selector jacks **(40)** inwardly to cause said needles **(22)** to move to the knit position and for moving said selector jacks **(40)** upwardly and downwardly to cause said needles **(22)** to move to the welt and tuck positions.

8. A knitting machine according to Claim 7 wherein each of the selector jacks **(40)** includes a master butt **(47)** and a pattern butt **(48)** thereon in longitudinal spaced relation and said actuating means comprises an actuating head **(53,60)** including a front cam face **(54,61)**, an upper cam face (55,62) and a lower cam face **(56,63)** arranged to engage said pattern butt **(48)** on said selector jack **(40)** to move said selector jack **(40).**

9. A knitting machine according to Claim 8 wherein said front cam face **(54,61)** of said actuating head **(53,60)** has an inwardly sloping surface **(54a,61a)** and a horizontal surface **(54b,61c)**,said upper cam face **(55,62)** has an upwardly sloping surface **(55a,62a,62b)**andahorizontal surface **(55b,62c)**, and said lower cam face (56,63) has a downwardly sloping surface **(56a,63a,63b)** and a horizontal surface

10. A knitting machine according to Claim 8 or 9 including a canceling cam **(57)** engageable with said master butts **(47)** on said selector jacks **(40)** for returning all of said selector jacks **(40)** to the same position or level as said selector jacks **(40)** approach said actuating means **(60).**

11. A knitting machine according to Claim 8, 9 or 10 including a welt cam **(70)** engageable with said master butts **(47)** on said selector jacks **(40)** when said selector jacks **(40)** are moved downwardly by said actuating means **(60)** for moving said selector jacks **(40)** to a position corresponding to the welt position of said needles **(22),** and a tuck cam **(71)** engageable with said master butts **(47)** on said selector jacks **(40)** when said selector jacks **(40)** are moved upwardly by said actuating means **(61)** for moving said selector jacks **(40)** to a position corresponding to the tuck position of said needles **(22).**

12. A knitting machine according to any of Claims 7 to 11 wherein each of said selector jacks **(40)** has a lateral projection **(42)** at its lower end, and selector jack support means **(44)** is engageable with said projections **(42)** to maintain said selector jacks **(40)** at a certain level when said selector jacks **(40)** are moved inwardly by said actuating means **(60)** and to assist in moving said selector jacks **(40)** upwardly and downwardly to maintain said selector jacks **(40)** in stable positions.

13. A knitting machine according to any of Claims 7 to 12 wherein said selector jacks **(40)** are resilient in a medial, stem portion thereof.

## Patentansprüche

1. Strickmaschine (20), umfassend Stricknadeln (22), die zwischen einer Strickposition, einer Fangposition und einer Randposition bewegbar sind, um Maschen in einem vorbestimmten Muster auszubilden, und mustergesteuerte Nadelauswahlmittel (50) zum Auswählen bestimmter Nadeln (22), um diese gemäß dem Muster zu der und zwischen den Strick-, Fang- und Randposition zu bewegen, **dadurch gekennzeichnet, daß** die Nadelauswahlmittel (50) umfassen:
einen piezoelektrischen Körper (51), der zwischen drei Arbeitspositionen bewegbar ist, die der Strick-, Fang- und Randposition der Nadeln (22) entsprechen,
erste Antriebsmittel (84) zum Veranlassen des piezoelektrischen Körpers (51), sich in eine seiner Arbeitspositionen zu bewegen,
zweite Antriebsmittel (85) zum Veranlassen des piezoelektrischen Körpers (51), sich in eine andere seiner Arbeitspositionen zu bewegen, und
dritte Antriebsmittel (86) zum Veranlassen des piezoelektrischen Körpers (51), sich in die verbleibende seiner Arbeitspositionen zu bewegen, wodurch der piezoelektrische Körper (51) eine Nadel (22) auswählt und sie veranlaßt, sich zwischen ihren drei Arbeitspositionen gemäß dem vorbestimmten Muster zu bewegen.

2. Strickmaschine (20) nach Anspruch 1, wobei die Nadelauswahlmittel (50) Steuermittel (81) zur Abgabe dreier Steuersignale aufweist, um die ersten, zweiten und dritten Antriebsmittel (84, 85, 86) zu steuern.

3. Strickmaschine (20) nach Anspruch 1 oder 2, wobei der piezoelektrische Körper (51) ein längliches Grundelement (51a) und zumindest ein piezoelektrisches Element (51b) aufweist, wobei das Element (51b) von dem Grundelement (51a) getragen wird und bei Anlegen einer Spannung eines ersten Potentials in eine erste Position, bei Anlegen einer Spannung eines zweiten Potentials , das unterschiedlich zum ersten Potential ist, in eine zweite Position, und bei Anlegen einer Spannung eines dritten Potentials, das zwischen dem ersten und dem zweiten Potential liegt, in eine dritte Position bewegbar ist.

4. Strickmaschine (20) nach Anspruch 3, wobei das erste und das zweite Potential Spannungen von gleichem Wert, aber entgegengesetzter Polarität sind.

5. Strickmaschine (20) nach Anspruch 3 oder 4, wobei das dritte Potential null ist.

6. Strickmaschine (20) nach Anspruch 3 oder 4, wobei das dritte Potential Ausgangssignale entgegengesetzter Polarität von zwei Kondensatoren umfaßt, welche schnell und abwechselnd solange angelegt werden, bis die Kondensatoren auf null entladen sind.

7. Strickmaschine nach Anspruch 1, einschließend Federheber (30), die mit den Stricknadeln (22) zum Bewegen der Stricknadeln (22) zwischen der Strickposition, der Fangposition und der Randposition betriebsfähig verbunden sind, und Auswahlheber (40) zum ausgewählten Betätigen der Federheber (30), um die Nadeln (22) zu bewegen, wobei die Nadelauswahlmittel (50) Betätigungsmittel (53, 60) zum Bewegen der Auswahlheber (40) nach innen, um die Nadeln (22) zu veranlassen, sich in die Strickposition zu bewegen, und zum Bewegen der Auswahlheber (40) nach oben und nach unten, um die Nadeln (22) zu veranlassen, sich in die Randposition und in die Fangposition zu bewegen, einschließen.

8. Strickmaschine nach Anspruch 7, wobei jeder der Auswahlheber (40) ein Meisterendstück (47) und ein Musterendstück (48) darauf in Längsrichtung zueinander beabstandet aufweist und wobei das Betätigungsmittel einen Betätigungskopf (53, 60) aufweist, der eine vordere Nockenfläche (54, 61), eine obere Nockenfläche (55, 62) und eine untere Nockenfläche (56, 63) aufweist, die so angeordnet sind, um mit dem Musterendstück (48) auf dem Auswahlheber (40) in Eingriff zu gelangen, um den Auswahlheber (40) zu bewegen.

9. Strickmaschine nach Anspruch 8, wobei die vordere Nockenfläche (54, 61) des Betätigungskopfs (53, 60) eine nach innen geneigte Oberfläche (54a, 61a) und eine horizontale Fläche (54b, 61 c) aufweist, wobei die obere Nockenflöche (55, 62) eine nach oben geneigte Fläche (55a, 62a, 62b) und eine horizontale Fläche (55b, 62c) aufweist und wobei die untere Nockenfläche (56, 63) eine nach unten geneigte Fläche (56a, 63a, 63b) und eine horizontale Fläche aufweist.

10. Strickmaschine nach Anspruch 8 oder 9, enthaltend eine Löschnocke (57), die mit den Meisterendstücken (47) auf den Auswahlhebern (40) zum Rücksetzen aller Auswahlheber (40) in dieselbe Position oder Ebene in Eingriff bringbar ist, wenn sich die Auswahlheber (40) dem Betätigungsmittel (60) nähern.

11. Strickmaschine nach Anspruch 8, 9 oder 10, enhaltend eine Oberrandnocke (70), die mit den Meisterendstücken (47) auf den Auswahlhebern (40) in Eingriff bringbar ist, wenn die Auswahlheber (40) durch das Betätigungsmittel (60)nach unten bewegt werden, um die Auswahlheber (40) in eine Position zu bewegen, die der Randposition der Nadeln (22) entspricht, und eine Fangnocke (71), die mit den Meisterendstücken (47) auf den Auswahlhebern (40) in Eingriff bringbar ist, wenn die Auswahlheber (40) durch das Betätigungsmittel (61)nach oben bewegt werden, um die Auswahlheber (40) in eine Position zu bewegen, die der Fangposition der Nadeln (22) entspricht.

12. Strickmaschine nach einem der Ansprüche 7 bis 11, wobei jeder der Auswahlheber (40) einen seitlichen Fortsatz (42) an seinem unteren Ende aufweist und wobei das Auswahlheberstützmittel (44) mit den Fortsätzen (42) in Eingriff bringbar ist, um die Auswahlheber (40) auf einer bestimmten Höhe zu halten, wenn die Auswahlheber (40) durch das Betätigungsmittel (60) nach innen bewegt werden, und um die Auswahlheber (40) beim Bewegen nach oben und unten zu unterstützen, um die Auswahlheber (40) in stabilen Positionen zu halten.

13. Strickmaschine nach einem der Ansprüche 7 bis 12, wobei die Auswahlheber (40) in einem mittigen Schaftabschnitt federnd sind.

## Revendications

1. Machine à tricoter (20), comprenant des aiguilles à tricoter (22) déplaçables entre des positions revers, pli cousu et maille pour former des points à boucle dans un motif prédéterminé, et un moyen de sélection d'aiguilles commandé par motif (50) pour sélectionner le déplacement d'aiguilles particulières (22) aux positions revers, pli cousu et maille, et entre celles-ci, suivant ledit motif, **caractérisée en ce que** le moyen de sélection d'aiguilles (50) comprend:
un corps piézoélectrique (51) déplaçable entre trois positions de fonctionnement correspondant aux positions revers, pli cousu et maille desdites aiguilles (22),
un premier moyen d'entraînement (84) pour provoquer le déplacement dudit corps piézoélectrique (51) à l'une de ses positions de fonctionnement,
un deuxième moyen d'entraînement (85) pour provoquer le déplacement dudit corps piézoélectrique (51) à une autre de ses positions de fonctionnement, et
un troisième moyen d'entraînement (86) pour provoquer le déplacement dudit corps piézoélectrique (51) à la position restante de ses positions de fonctionnement, de manière que ledit corps piézoélectrique (51) sélectionne et provoque le déplacement d'une aiguille (22) entre ses trois positions de fonctionnement, suivant ledit motif prédéterminé.

2. Machine à tricoter (20) selon la revendication 1, dans laquelle ledit moyen de sélection d'aiguilles (50) comprend un moyen de commande (81) pour fournir trois signaux de commande pour commander lesdits premier, deuxième et troisième moyens d'entraînement (84, 85, 86).

3. Machine à tricoter (20) selon la revendication 1 ou 2, dans laquelle ledit corps piézoélectrique (51) comprend un élément de base allongé (51a), et au moins un élément piézoélectrique (51b) supporté par ledit élément de base (51a) et déplaçable à une première position après application d'une tension d'un premier potentiel, déplaçable à une deuxième position après application d'une tension d'un deuxième potentiel différent dudit premier potentiel, et déplaçable à une troisième position après application d'une tension d'un troisième potentiel, intermédiaire entre le premier et le deuxième potentiels.

4. Machine à tricoter (20) selon la revendication 3, dans laquelle lesdits premier et deuxième potentiels sont des tensions de valeur égale mais de polarités opposées.

5. Machine à tricoter (20) selon la revendication 3 ou 4, dans laquelle ledit troisième potentiel est zéro.

6. Machine à tricoter (20) selon la revendication 3 ou 4, dans laquelle ledit troisième potentiel comprend des sorties de polarités opposées de deux condensateurs appliquées rapidement et alternativement jusqu'à ce que lesdits condensateurs soient déchargés à zéro.

7. Machine à tricoter selon la revendication 1, comprenant des broches-ressorts (30) associées en fonctionnement avec lesdites aiguilles à tricoter (22) pour déplacer lesdites aiguilles à tricoter (22) entre les positions revers, pli cousu et maille, et des broches de sélection (40) pour activer sélectivement lesdites broches-ressorts (30) pour déplacer lesdites aiguilles (22), ledit moyen de sélection d'aiguilles (50) comprenant des moyens de commande (53, 60) pour déplacer lesdites broches de sélection (40) vers l'intérieur pour provoquer le déplacement desdites aiguilles (22) à la position maille, et pour déplacer lesdites broches de sélection (40) vers le haut et vers le bas pour provoquer le déplacement desdites aiguilles (22) aux positions revers et pli cousu.

8. Machine à tricoter selon la revendication 7, dans laquelle chacune des broches de sélection (40) comprend sur celle-ci un talon principal (47) et un talon de motif (48) en relation espacée longitudinale, et dans laquelle ledit moyen de commande comprend une tête de commande (53, 60) incluant une face de came avant (54, 61), une face de came supérieure (55, 62) et une face de came inférieure (56, 63), disposées pour coopérer avec ledit talon de motif (48) sur ladite broche de sélection (40) pour déplacer ladite broche de sélection (40).

9. Machine à tricoter selon la revendication 8, dans laquelle ladite face de came avant (54, 61) de ladite tête de commande (53, 60) a une surface inclinée vers l'intérieur (54a, 61a) et une surface verticale (54b, 61b), ladite face de came supérieure (55, 62) a une surface inclinée vers le haut (55a, 62a, 62b) et une surface horizontale (55b, 62c), et ladite face de came inférieure (56, 63) a une surface inclinée vers le bas (56a, 63a, 63b) et une surface horizontale (56b).

10. Machine à tricoter selon la revendication 8 ou 9, comprenant une came d'annulation (57) qui peut coopérer avec lesdits talons principaux (47) sur lesdites broches de sélection (40) pour ramener toutes lesdites broches de sélection (40) à la même position ou au même niveau lorsque lesdites broches de sélection (40) approchent dudit moyen de commande (60).

11. Machine à tricoter selon la revendication 8, 9 ou 10, comprenant une came de revers (70) qui peut coopérer avec lesdits talons principaux (47) sur lesdites broches de sélection (40) lorsque lesdites broches de sélection (40) sont déplacées vers le bas par ledit moyen de commande (60), pour déplacer lesdites broches de sélection (40) à une position correspondant à la positon de revers desdites aiguilles (22), et une came de pli cousu (71) qui peut coopérer avec lesdits talons principaux (47) sur lesdites broches de sélection (40) lorsque lesdites broches de sélection (40) sont déplacées vers le haut par ledit moyen de commande (61) pour déplacer lesdites broches de sélection (40) à une position correspondant à la positon de pli cousu desdites aiguilles (22).

12. Machine à tricoter selon l'une quelconque des revendications 7 à 11, dans laquelle chacune desdites broches de sélection (40) a une saillie latérale (42) à son extrémité inférieure, et dans laquelle le moyen de support de broches de sélection (44) peut être engagé avec lesdites saillies (42) pour maintenir lesdites broches de sélection (40) à un certain niveau lorsque lesdites broches de sélection (40) sont déplacées vers l'intérieur par ledit moyen de commande (60), et pour aider le déplacement desdites broches de sélection (40) vers le haut et vers le bas pour maintenir lesdites broches de sélection (40) dans des positions stables.

13. Machine à tricoter selon l'une quelconque des revendications 7 à 12, dans laquelle lesdites broches de sélection (40) sont résilientes dans une partie médiane de la tige de celles-ci.
